# EUROPEAN PATENT APPLICATION

(11) **EP 4 106 133 A1**
(43) Date of publication of application: **21.12.2022**
(21) Application number: 21886611.9
(22) Date of filing: 08.10.2021
(51) Int. Cl.: H02J 7/00, H02J 7/34, G01R 31/382

(54) **BATTERY MANAGEMENT DEVICE AND METHOD, AND BATTERY MANAGEMENT SYSTEM**

(30) Priority: 29.10.2020 KR 20200142547
(71) Applicant: LG Energy Solution, Ltd., Seoul 07335 (KR)
(72) Inventor: HONG, Jun Hyeon, Daejeon 34122 (KR)
(74) Representative: Plasseraud IP
(86) International application number: PCT/KR2021/013937
(87) International publication number: WO 2022/092617

(57) **Abstract**

A battery management apparatus includes a sensing unit sensing an operating state of a target device, a power managing unit managing power supply from an auxiliary battery based on the operating state of the target device, and a control unit performing a cell balancing operation for a plurality of battery cells according to an operating mode determined based on the operating state of the target device.

## Description

### [Technical Field]

### CROSS-REFERENCE TO RELATED APPLICATION

This application claims priority to and the benefit of Korean Patent Application No. 10-2020-0142547 filed in the Korean Intellectual Property Office on October 29, 2020, the entire contents of which are incorporated herein by reference.

### TECHNICAL FIELD

Embodiments disclosed in this document relate to a battery management apparatus and method, and a battery management system.

### [Background Art]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

Furthermore, the secondary battery is generally used as a battery pack including a battery module where a plurality of battery cells are connected to one another in series and/or in parallel. The battery pack may be managed and controlled by a battery management system in terms of a state and an operation.

For an electric vehicle using a battery including such battery cells, multiple battery cells are mounted, such that balancing for the battery cells is a key issue. However, when a cell balancing operation is performed while the power of the electric vehicle is turned off, the power of an auxiliary battery of the vehicle is consumed, which may shorten the lifespan of the auxiliary battery or cause discharge, and make the operation of the electric vehicle impossible.

### [Disclosure]

### [Technical Problem]

Embodiments disclosed herein aim to provide a battery management apparatus and method, and a battery management system in which a battery cell balancing operation may be performed without power consumption of an auxiliary battery of a target device in a power-off state of the target device.

Technical problems of the embodiments disclosed herein are not limited to the above-described technical problems, and other unmentioned technical problems would be clearly understood by one of ordinary skill in the art from the following description.

### [Technical Solution]

A battery management apparatus according to an embodiment disclosed herein includes a sensing unit sensing an operating state of a target device, a power managing unit managing power supply from an auxiliary battery based on the operating state of the target device, and a control unit performing a cell balancing operation for a plurality of battery cells according to an operating mode determined based on the operating state of the target device.

In an embodiment, the power managing unit may operate by using power originating from a battery module including the plurality of battery cells, when the target device is in a power-on state.

In an embodiment, the auxiliary battery may be charged by using the power originating from the battery module, when the power managing unit is supplied with power from the battery module.

In an embodiment, the power managing unit may be supplied with power from the auxiliary battery, when the target device is in a power-off state.

In an embodiment, when the target device is in a power-on state, the control unit may operate in a normal mode, calculate a cell balancing time for the plurality of battery cells, and perform the cell balancing operation based on the calculated time.

In an embodiment, when the target device is switched to the power-off state before the cell balancing operation is terminated, the control unit may switch the operating mode to the low-power mode and perform the cell balancing operation for a remaining time of the calculated time.

In an embodiment, the control unit may switch the operating mode to the normal mode every preset time and monitor a voltage of the plurality of battery cells in the normal mode to re-calculate the cell balancing time.

In an embodiment, the preset time may be determined based on at least one of specifications of the target device, characteristics of the plurality of battery cells, and a capacity of the auxiliary battery.

A battery management method according to an embodiment disclosed herein includes sensing an operating state of a target device, managing power supply from an auxiliary battery based on the operating state of the target device, and performing a cell balancing operation for a plurality of battery cells according to an operating mode determined based on the operating state of the target device.

In an embodiment, the managing of the power supply from the auxiliary battery based on the operating state of the target device may include being supplied with power from the auxiliary battery when the target device is in a power-off state.

In an embodiment, the performing of the cell balancing operation for the battery cells according to the operating mode determined based on the operating state of the target device may include operating in a normal mode, calculating a cell balancing time for the plurality of battery cells, and performing the cell balancing operation based on the calculated time , when the target device is in a power-on state.

In an embodiment, the performing of the cell balancing operation for the battery cells according to the operating mode determined based on the operating state of the target device may include switching the operating mode to the low-power mode and performing the cell balancing operation for a remaining time of the calculated time , when the target device is switched to the power-off state before the cell balancing operation is terminated.

In an embodiment, the battery management method may further include determining whether a preset time has elapsed and monitoring a voltage of the plurality of battery cells in the normal mode to re-calculate the cell balancing time, in a case where the preset time has elapsed.

A battery management system according to an embodiment disclosed herein includes a battery module including a plurality of battery cells and supplying power to a target device, a battery management apparatus performing a cell balancing operation for a plurality of battery cells according to an operating mode determined based on an operating state of the target device, and generating a control command based on the operating state of the target device, a switch connecting or disconnecting a first auxiliary battery of the target device to or from the battery management apparatus in response to the control command, and a second auxiliary battery supplying power to the battery management apparatus.

In an embodiment, the battery management apparatus may generate a control command for opening the switch to disconnect the first auxiliary battery from the battery management apparatus, when the target device is in a power-off state.

In an embodiment, the battery management apparatus may generate a control command for short-circuiting the switch when the target device is in the power-off state, and the second auxiliary battery is charged using power originating from the battery module when the switch is short-circuited.

In an embodiment, when the target device is in a power-on state, the battery management apparatus may operate in a normal mode, calculate a cell balancing time for the plurality of battery cells, and perform the cell balancing operation based on the calculated time .

In an embodiment, when the target device is switched to the power-off state before the cell balancing operation is terminated, the battery management apparatus may switch the operating mode to the low-power mode and perform the cell balancing operation for a remaining time of the calculated time .

### [Advantageous Effects]

A battery management apparatus and method and a battery management system according to an embodiment disclosed herein may perform a battery cell balancing operation without power consumption of an auxiliary battery of a target device in a power-off state of the target device.

The battery management apparatus and method and the battery management system according to an embodiment disclosed herein may charge the auxiliary battery of the battery management apparatus in the power-on state of the target device.

### [Description of Drawings]

FIGS. 1 and 2 are block diagrams of a battery management system according to an embodiment disclosed herein.
FIG. 3 is a view for describing in detail an operation of a battery management system, according to an embodiment disclosed herein.
FIG. 4 is a block diagram of a battery management apparatus according to an embodiment disclosed herein.
FIG. 5 is a view for describing an operation of a battery management apparatus, according to an embodiment disclosed herein.
FIG. 6 is a flowchart of a battery management method according to an embodiment disclosed herein.
FIG. 7 is a flowchart illustrating in more detail a battery management method according to an embodiment disclosed herein.
FIG. 8 illustrates a computing system that executes another battery management method, according to an embodiment disclosed herein.

### [Mode for Invention]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These term is used merely for distinguishing one component from another component and does not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

In the present specification, a 'target device' may include an electrical, electronic, or mechanical device that operates by receiving power from a battery pack including a plurality of battery cells, and herein, the 'target device' is described as an example of an electric vehicle (EV), but is not limited thereto.

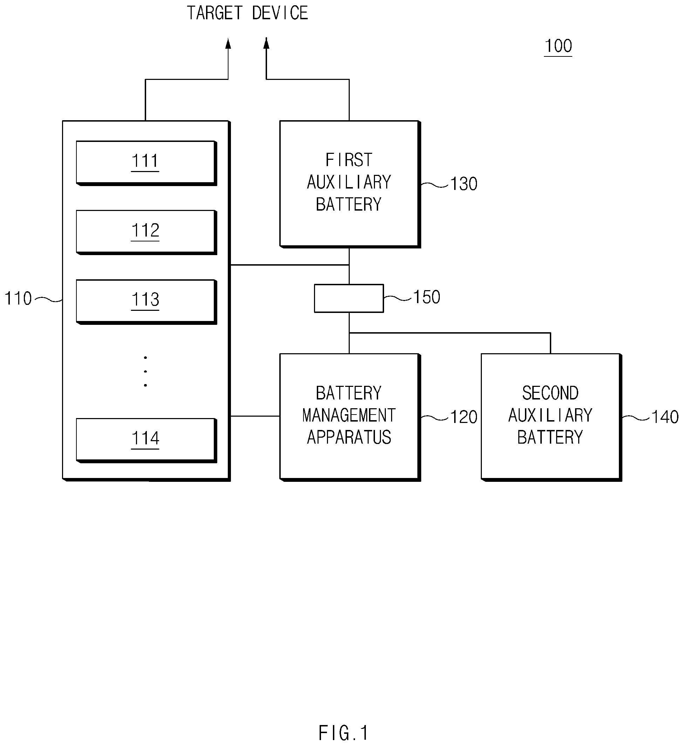

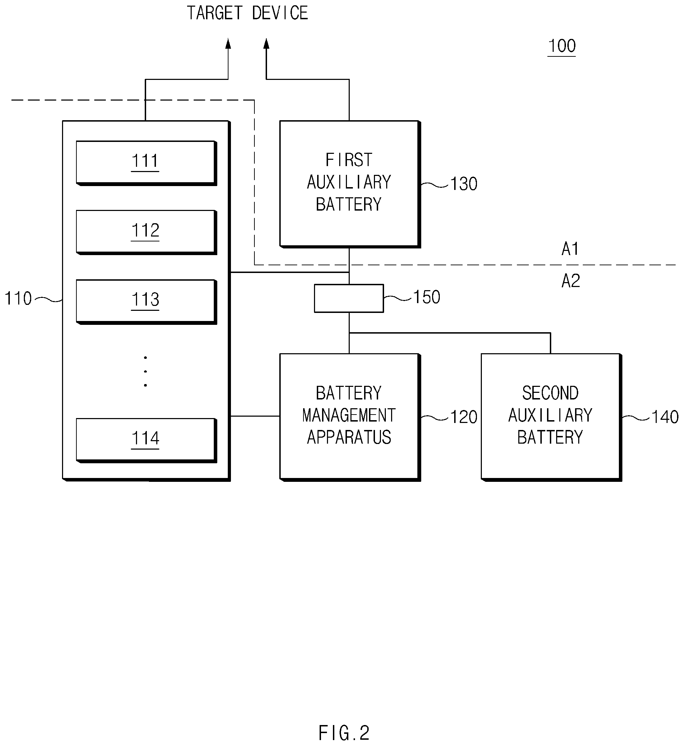

FIGS. 1 and 2 are block diagrams of a battery management system according to an embodiment disclosed herein.

Referring to FIG. 1, a battery management system 100 according to an embodiment disclosed herein may include a battery module 110, a battery management apparatus 120, a first auxiliary battery 130, a second auxiliary battery 140, and a first switch 150.

The battery module 110 may include a plurality of battery cells 111, 112, 113, and 114. Although the plurality of battery cells are illustrated as four in FIG. 1, the present invention is not limited thereto, and the battery module 110 may include n battery cells (n is a natural number greater than or equal to 2). The battery module 110 may supply power to a target device. To this end, the battery module 110 may be electrically connected to the target device (not shown).

The plurality of battery cells 111, 112, 113, and 114 may be a lithium ion (Li-ion) battery, an Li-ion polymer battery, a nickel-cadmium (Ni-Cd) battery, a nickel hydrogen (Ni-MH) battery, etc., and may not be limited thereto. Meanwhile, although one battery module 110 is illustrated in FIG. 1, the battery module 110 may be configured in plural according to an embodiment.

The battery management apparatus 120 may manage and/or control a state and/or an operation of the battery module 110. For example, the battery management apparatus 120 may manage and/or control the states and/or operations of the plurality of battery cells 111, 112, 113, and 114 included in the battery module 110. The battery management apparatus 120 may manage charging and/or discharging of the battery module 110.

In addition, the battery management apparatus 120 may monitor a voltage, a current, a temperature, etc., of the battery module 110 and/or each of the plurality of battery cells 111, 112, 113, and 114 included in the battery module 110. A sensor or various measurement modules for monitoring performed by the battery management apparatus 120, not shown, may be additionally installed in the battery module 110, a charging/discharging path, any position of the battery module 110, etc. The battery management apparatus 120 may calculate a parameter indicating a state of the battery module 110, e.g., a state of charge (SOC), a state of health (SOH) etc., based on a measurement value such as monitored voltage, current, temperature, etc.

The battery management apparatus 120 may calculate a cell balancing time for the plurality of battery cells 111, 112, 113, and 114. For example, the battery management apparatus 120 may calculate a cell balancing time based on an SOC of each of the plurality of battery cells 111, 112, 113, and 114. The battery management apparatus 120 may determine a cell balancing target based on the SOC of each of the plurality of battery cells 111, 112, 113, and 114. The battery management apparatus 120 may perform a cell balancing operation based on the cell balancing time for a battery cell determined as the cell balancing target among the plurality of battery cells 111, 112, 113, and 114.

The battery management apparatus 120 may sense an operating state of a target device (not shown). For example, the battery management apparatus 120 may directly sense the operating state of the target device, or detect the operating state of the target device by receiving information about the operating state from the target device. The battery management apparatus 120 may manage power supply from the second auxiliary battery 140 based on the operating state of the target device. For example, the battery management apparatus 120 may operate by receiving power originating from the battery module 110 or by receiving power from the second auxiliary battery 140, based on the operating state of the target device. To this end, the battery management apparatus 120 may generate a control command for controlling opening and short-circuiting of the first switch 150, based on the operating state of the target device.

For example, when the target device is in a power-off state, the battery management apparatus 120 may be supplied with power from the second auxiliary battery 140 by opening the first switch 150. That is, the battery management apparatus 120 may cut off power supply from the first auxiliary battery 130 when the target device is in the power-off state. Thus, the battery management apparatus 120 may perform the cell balancing operation without consuming the power of the first auxiliary battery 130 of the target device while the target device is in the power-off state.

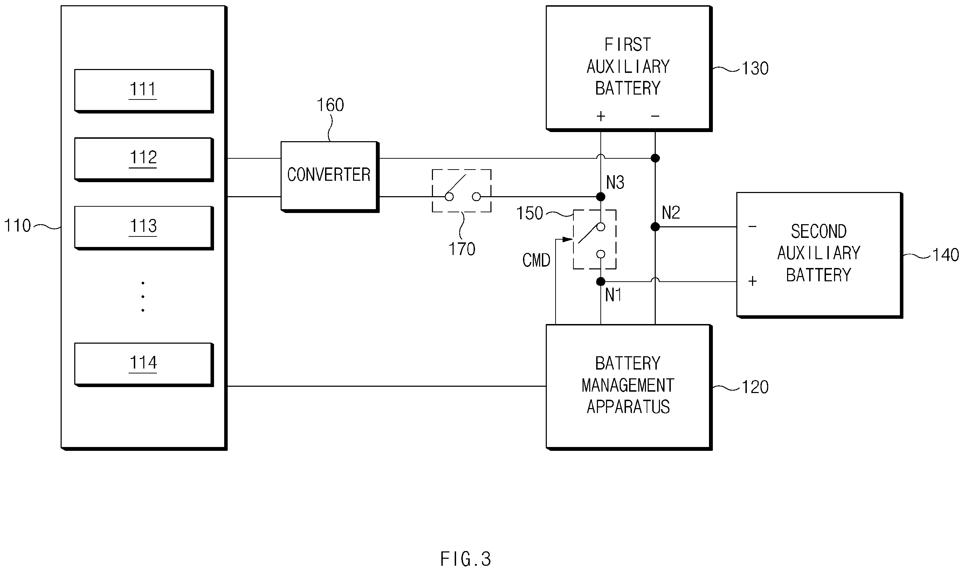

Meanwhile, the battery management apparatus 120 may short-circuit the first switch 150 when the target device is in a power-on state, thereby operating using the power originating from the battery module 110 and/or the power supplied from the first auxiliary battery 130. In this case, the first auxiliary battery 130 and the second auxiliary battery 140 may be charged using the power originating from the battery module 110. This will be described in more detail with reference to FIG. 3 below.

The battery management apparatus 120 may determine an operating mode based on the operating state of the target device. For example, the battery management apparatus 120 may determine the operating mode as a normal mode when the target device is in the power-on state, and determine the operating mode as a low-power mode when the target device is in the power-off state. Here, the low-power mode may be defined as an operating mode where power consumption of the battery management apparatus 120 is lower than in the normal mode, and in one aspect, the low-power mode may be defined as an operating mode in which the battery management device 120 performs contents or time of the operation restrictively compared to in the normal mode.

When operating in the normal mode, the battery management apparatus 120 may calculate the cell balancing time for the plurality of battery cells 111, 112, 113, and 114 and perform the cell balancing operation based on the calculated cell balancing time. When operating in the low-power mode, the battery management apparatus 120 may perform the cell balancing operation based on the cell balancing time calculated in the normal mode. In addition, when the operating mode is switched from the normal mode to the low-power mode according to the operating state of the target device, the battery management apparatus 120 may perform the cell balancing operation for the remaining time of the cell balancing time calculated in the normal mode, except for a time in which the cell balancing operation is performed. Accordingly, when the battery management apparatus 120 operates in the low-power mode, power consumption of the second auxiliary battery 140 may be reduced.

In addition, the battery management apparatus 120 may switch the operating mode from the low-power mode to the normal mode every preset time. The battery management apparatus 120 may re-calculate a cell balancing time by monitoring a voltage of the plurality of battery cells 111, 112, 113, and 114. Here, the preset time may be determined based on at least some of the specifications of the target device, characteristics of the plurality of battery cells 111, 112, 113, and 114, and the capacity of the second auxiliary battery 140.

Also, the battery management apparatus 120 may determine whether the cell balancing operation is completed. For example, the battery management apparatus 120 may determine that cell balancing is completed in a case where a reference time has elapsed, or determine whether cell balancing is completed based on the SOC of the plurality of battery cells 111, 112, 113, and 114. Here, the reference time may be determined based on at least some of the specifications of the target device, characteristics of the plurality of battery cells 111, 112, 113, and 114, and the capacity of the second auxiliary battery 140.

As such, the battery management apparatus 120 may operate in the low-power mode and then be switch to the normal mode every preset time to re-calculate the cell balancing time, and may perform the cell balancing operation only for the remaining time when the battery management apparatus 120 is switched back to the low-power mode, thereby reducing power consumption of the secondary auxiliary battery 140.

The first auxiliary battery 130 may basically supply power to the target device. For example, the first auxiliary battery 130 may be an auxiliary power provided for driving and/or an operation of the target device. Also, the first auxiliary battery 130 may supply power to the battery management apparatus 120 electrically connected through the first switch 150. For example, the first auxiliary battery 130 may supply power to the battery management apparatus 120 when the first switch 150 is short-circuited. Meanwhile, the first auxiliary battery 130 may be charged using the power originating from the battery module 110, when the target device is in the power-on state.

The second auxiliary battery 140 may supply power to the battery management apparatus 120. The second auxiliary battery 140 may be connected in parallel with the first auxiliary battery 130, and may be electrically connected to the first auxiliary battery 130 through the first switch 150. For example, the second auxiliary battery 140 may be an auxiliary power provided for driving and/or an operation of the battery management apparatus 120. Meanwhile, the second auxiliary battery 140 may be charged using the power originating from the battery module 110 identically to the first auxiliary battery 130, when the target device is in the power-on state. This may be possible by connecting the second auxiliary battery 140 to the first auxiliary battery 130 in parallel.

The first switch 150 may be electrically connected to the battery management apparatus 120, the first auxiliary battery 130, and the second auxiliary battery 140. The first switch 150 may be opened or short-circuited in response to a control command transmitted from the battery management apparatus 120. For example, the battery management apparatus 120 may generate a control command for opening the first switch 150 when the target device is in the power-on state, and generate a control command for short-circuiting the first switch 150 when the target device is in the power-off state.

Referring to FIG. 2, the battery management system 100 according to an embodiment disclosed herein may be exemplarily divided into a target device area A1 and a battery management system area A2.

For example, the target device area A1 may be defined as an area including components provided in the target device and may be defined as an area including the first auxiliary battery 130.

The battery management system area A2 may be defined as an area including components related to a battery mounted in the target device, and may be defined as an area including the battery module 110, the battery management apparatus 120, the second auxiliary battery 140, and the switch 150. In one aspect, the battery management system area A2 may be defined as being included in a battery pack. However, according to an embodiment, the first switch 150 may be included in the target device area A1.

FIG. 3 is a view for describing in detail an operation of a battery management system, according to an embodiment disclosed herein.

Referring to FIG. 3, when the target device (not shown) is in the power-on state, the first auxiliary battery 130 and the second auxiliary battery 140 may be charged using the power originating from the battery module 110. More specifically, the first switch 150 and the second switch 170 may be controlled to be short-circuited when the target device is in the power-on state. For example, the first switch 150 may be short-circuited in response to a control command cmd transmitted from the battery management apparatus 120. The second switch 170 may be controlled to be short-circuited by the target device, but is not limited thereto, and may be controlled by the battery management apparatus 120 according to an embodiment.

When the first switch 150 and the second switch 170 are short-circuited, the power transmitted from the battery module 110 may be converted through a converter 160, and may be delivered to the battery management apparatus 120, the first auxiliary battery 130, and the second auxiliary battery 140. Here, the converter 160 may include a direct current-to-direct current (DC-DC) converter. Thus, when the target device is in the power-on state, the first auxiliary battery 130 and the second auxiliary battery 140 may be charged using the power originating from the battery module 110.

Meanwhile, the battery management apparatus 120 may control the first switch 150 to be opened when the target device is in the power-off state. When the first switch 150 is opened, the battery management apparatus 120 may operate using the power supplied from the second auxiliary battery 140. Thus, power consumption of the first auxiliary battery 130 due to the battery management apparatus 120 may be prevented when the target device is in the power-off state. Meanwhile, the second switch 170 may be controlled to be opened by the target device when the target device is in the power-off state.

Hereinafter, a connection relationship among the battery module 110, the battery management apparatus 120, the first auxiliary battery 130, the second auxiliary battery 140, the first switch 150, the converter 160, and the second switch 170 will be described in detail.

The battery management apparatus 120, the first auxiliary battery 130, and the second auxiliary battery 140 may be connected in parallel with the battery module 110. More specifically, the battery management apparatus 120, the first auxiliary battery 130, and the second auxiliary battery 140 may be connected in parallel with the battery module 110 with respect to a second node N2 and a third node N3.

The first auxiliary battery 130 and the second auxiliary battery 140 may be connected in parallel with the battery management apparatus 120. More specifically, the first auxiliary battery 130 and the second auxiliary battery 140 may be connected in parallel with the battery management apparatus 120 through a first node N1 and the second node N2.

More specifically, positive (+) terminals of the battery management apparatus 120 and the second auxiliary battery 140 may be connected to each other through the first node N1. A negative (-) terminal of the first auxiliary battery 130 and a negative (-) terminal of the second auxiliary battery 140 may be connected to the converter 160 through the second node N2. The positive (+) terminal of the first auxiliary battery 130 may be connected to the first switch 150 and the second switch 170 through the third node N3.

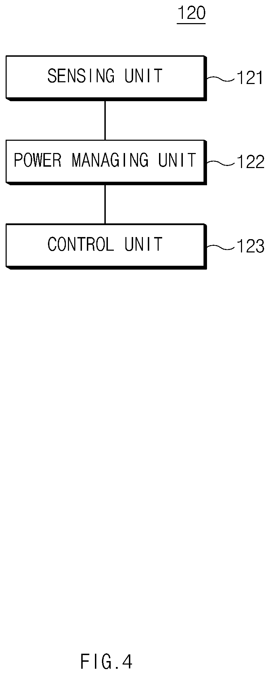

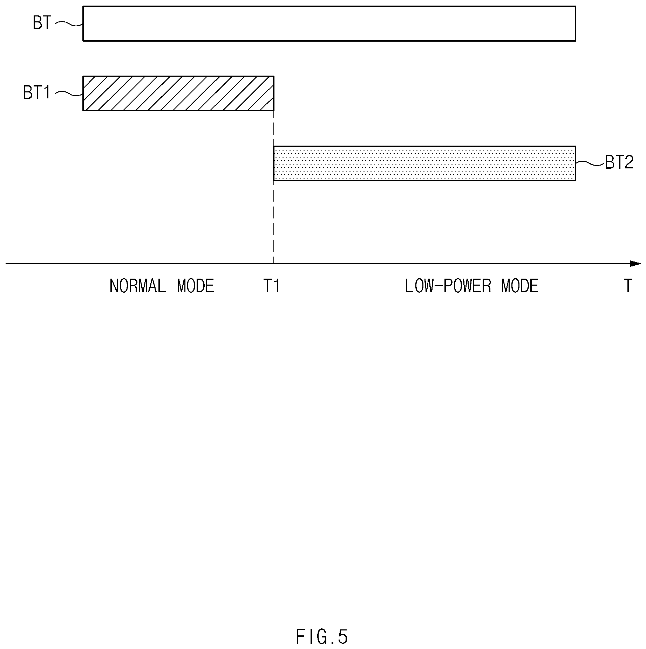

Hereinafter, the battery management apparatus 120 according to an embodiment disclosed herein will be described in detail with reference to FIGS. 4 and 5.

FIG. 4 is a block diagram of a battery management apparatus according to an embodiment disclosed herein. FIG. 5 is a view for describing an operation of a battery management apparatus, according to an embodiment disclosed herein.

Referring to FIG. 4, the battery management apparatus 120 according to an embodiment disclosed herein may include a sensing unit 121, a power managing unit 122, and a control unit 123.

The sensing unit 121 may sense the operating state of the target device. The sensing unit 121 may transmit a sensing result to the power managing unit 122 and/or the control unit 123. For example, the sensing unit 121 may directly sense the operating state of the target device, or detect the operating state of the target device by receiving information about the operating state from the target device.

The battery managing unit 122 may manage power supply from the second auxiliary battery 140 based on the sensing result. For example, the power managing unit 122 may be supplied with the power originating from the battery module 110 or may be supplied with the power from the second auxiliary battery 140, based on the operating state of the target device. To this end, the power managing unit 122 may generate a control command for controlling opening and short-circuiting of the first switch 150, based on the operating state of the target device.

For example, when the target device is in the power-off state, the power managing unit 122 may be supplied with power from the second auxiliary battery 140 by opening the first switch 150. Thus, the battery management apparatus 120 may perform the cell balancing operation without consuming the power of the first auxiliary battery 130 of the target device while the target device is in the power-off state.

Meanwhile, the power managing unit 122 may be supplied with the power originating from the battery module 110 and/or the power from the first auxiliary battery 130 by short-circuiting the first switch 150, when the target device is in the power-on state. Thus, when the target device is in the power-on state, the first auxiliary battery 130 and the second auxiliary battery 140 may be charged using the power originating from the battery module 110 through the converter 160 (see FIG. 3). This may be possible by connecting the second auxiliary battery 140 to the first auxiliary battery 130 in parallel.

The control unit 123 may determine the operating mode based on the sensing result of the sensing unit 121. For example, the control unit 123 may determine the operating mode as the normal mode when the target device is in the power-on state, and determine the operating mode as the low-power mode when the target device is in the power-off state. Here, the low-power mode may be defined as an operating mode where power consumption of the battery management apparatus 120 is lower than in the normal mode, and in one aspect, the low-power mode may be defined as an operating mode in which the battery management device 120 performs contents or time of the operation restrictively compared to in the normal mode.

Referring to FIG. 5, when operating in the normal mode, the control unit 123 may calculate a cell balancing time BT for the plurality of battery cells 111, 112, 113, and 114 and perform the cell balancing operation based on the calculated cell balancing time BT.

When operating in the low-power mode, the control unit 123 may perform the cell balancing operation based on the cell balancing time BT calculated in the normal mode. In addition, when the operating mode is switched from the normal mode to the low-power mode at a predetermined time t₁ according to the operating state of the target device, the control unit 123 may perform the cell balancing operation for a remaining time BT2 of the cell balancing time calculated in the normal mode, except for a cell balancing time BT1 in which the cell balancing operation is performed.

In addition, the control unit 123 may switch the operating mode from the low-power mode to the normal mode every preset time. The control unit 123 may re-calculate the cell balancing time by monitoring a voltage of the plurality of battery cells 111, 112, 113, and 114, in the normal mode. As such, the control unit 123 may operate in the low-power mode and then be switched to the normal mode every preset time to re-calculate the cell balancing time, and may perform the cell balancing operation only for the remaining time when the battery management apparatus 120 is switched back to the low-power mode, thereby reducing power consumption of the secondary auxiliary battery 140. Here, the preset time may be determined based on at least some of the specifications of the target device, characteristics of the plurality of battery cells 111, 112, 113, and 114, and the capacity of the second auxiliary battery 140.

In addition, the control unit 123 may determine whether the cell balancing operation is completed. For example, the control unit 123 may determine that cell balancing is completed in a case where a reference time has elapsed, or determine whether cell balancing is completed based on the SOC of the plurality of battery cells 111, 112, 113, and 114. Here, the reference time may be determined based on at least some of the specifications of the target device, characteristics of the plurality of battery cells 111, 112, 113, and 114, and the capacity of the second auxiliary battery 140.

Meanwhile, the power managing unit 122 and the control unit 123 are illustrated as separate components in FIG. 4, but may also be configured as one component (e.g., a processor) depending on an embodiment.

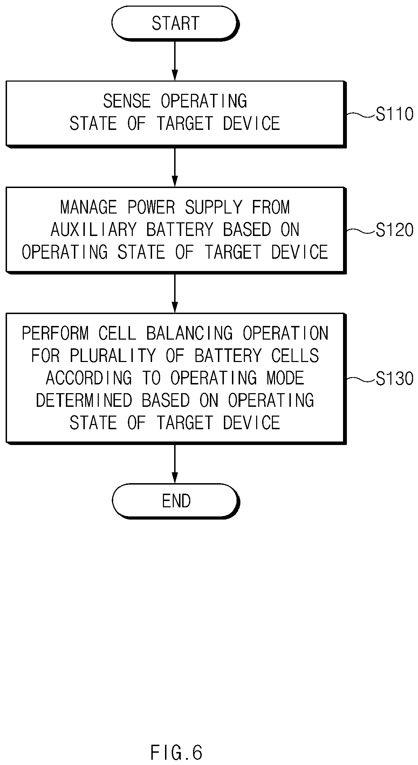

FIG. 6 is a flowchart of a battery management method according to an embodiment disclosed herein.

Referring to FIG. 6, a battery management method according to an embodiment disclosed herein may include operation S110 of sensing an operating state of a target device, operation S120 of managing power supply from an auxiliary battery based on the operating state of the target device, and operation S130 of performing a cell balancing operation for a plurality of battery cells according to an operating mode determined based on the operating state of the target device.

Hereinbelow, operations S110 through S130 will be described in detail with reference to FIG. 4.

In operation S110, the sensing unit 121 may sense the operating state of the target device. The sensing unit 121 may transmit a sensing result to the power managing unit 122 and/or the control unit 123.

In operation S120, the battery managing unit 122 may manage power supply from the second auxiliary battery 140 based on the sensing result. For example, when the target device is in the power-off state, the power managing unit 122 may be supplied with power from the second auxiliary battery 140 by opening the first switch 150. Thus, the battery management apparatus 120 may perform the cell balancing operation without consuming the power of the first auxiliary battery 130 of the target device while the target device is in the power-off state.

In addition, the power managing unit 122 may be supplied with the power originating from the battery module 110 and/or the power from the first auxiliary battery 130 by short-circuiting the first switch 150, when the target device is in the power-on state.

In operation S130, the control unit 123 may determine the operating mode based on the sensing result of the sensing unit 121. For example, the control unit 123 may determine the operating mode as the normal mode when the target device is in the power-on state, and determine the operating mode as the low-power mode when the target device is in the power-off state. Here, the low-power mode may be defined as an operating mode where power consumption of the battery management apparatus 120 is lower than in the normal mode, and in one aspect, the low-power mode may be defined as an operating mode in which the battery management device 120 performs contents or time of the operation restrictively compared to in the normal mode.

When operating in the normal mode, the control unit 123 may calculate the cell balancing time BT for the plurality of battery cells 111, 112, 113, and 114 and perform the cell balancing operation based on the calculated cell balancing time BT.

When operating in the low-power mode, the control unit 123 may perform the cell balancing operation based on the cell balancing time BT calculated in the normal mode. In addition, when the operating mode is switched from the normal mode to the low-power mode at a predetermined time t₁ according to the operating state of the target device, the control unit 123 may perform the cell balancing operation for a remaining time BT2 of the cell balancing time calculated in the normal mode, except for a cell balancing time BT1 in which the cell balancing operation is performed.

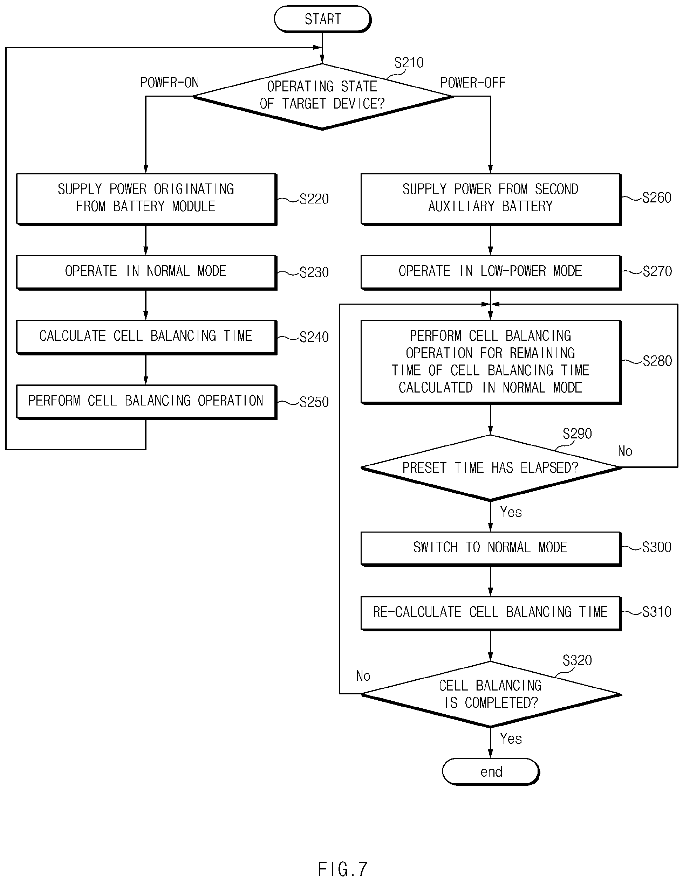

FIG. 7 is a flowchart illustrating in more detail a battery management method according to an embodiment disclosed herein.

Referring to FIG. 7, the battery management method according to an embodiment disclosed herein may include operation S210 of sensing an operating state of a target device, operation S220 of receiving power originating from a battery module, operation S230 of operating in the normal mode, operation S240 of calculating a cell balancing time, operation S250 of performing a cell balancing operation, operation S260 of receiving power form a second auxiliary battery, operation S270 of operating in the low-power mode, operation S280 of performing the cell balancing operation for the remaining time of the cell balancing time calculated in the normal operation, operation S290 of determining whether a preset time has elapsed, operation S300 of switching to the normal mode, operation S310 of re-calculating the cell balancing time, and operation S320 of determining whether cell balancing is completed.

Hereinbelow, operations S210 through S320 will be described in detail with reference to FIG. 4.

As a result of sensing in operation S210, when the target device is in the power-on state, operations S220 to S250 may be performed.

In operation S210, the sensing unit 121 may sense the operating state of the target device. The sensing unit 121 may transmit a sensing result to the power managing unit 122 and/or the control unit 123.

In operation S220, the power managing unit 122 may be supplied with the power originating from the battery module 110 and/or the power from the first auxiliary battery 130 by short-circuiting the first switch 150, when the target device is in the power-on state.

In operation S230 , the control unit 123 may determine the operating mode as the normal mode and operate the battery management apparatus 120 in the normal mode.

In operation S240, the control unit 123 may calculate a cell balancing time for each of the plurality of battery cells 111, 112, 113, and 114.

In operation S250, the control unit 123 may perform a cell balancing operation for the plurality of battery cells 111, 112, 113, and 114.

As a result of sensing in operation S210, when the target device is in the power-off state, operations S260 to S290 may be performed.

In operation S260, when the target device is in the power-off state, the power managing unit 122 may be supplied with power from the second auxiliary battery 140 by opening the first switch 150. That is, the power managing unit 122 may cut off power supply from the first auxiliary battery 130 when the target device is in the power-off state.

In operation S270 , the control unit 123 may determine the operating mode as the low-power mode and operate the battery management apparatus 120 in the low-power mode.

In operation S280, the control unit 123 may perform the cell balancing operation for the remaining time of the cell balancing time calculated in the normal mode, except for the time in which the cell balancing operation is performed.

In operation S290, the control unit 123 may determine whether the preset time has elapsed. In a case where the preset time has elapsed as a result of performing operation S290, operations S300 to S320 may be performed.

In operation S300, the control unit 123 may switch the operating mode to the normal mode.

In operation S310, the control unit 123 may monitor the plurality of battery cells 111, 112, 113, and 114 to re-calculate a cell balancing time.

In operation S320, the control unit 123 may determine whether the cell balancing operation is completed. For example, the control unit 123 may determine that cell balancing is completed in a case where a reference time has elapsed, or determine whether cell balancing is completed based on the SOC of the plurality of battery cells 111, 112, 113, and 114.

When the cell balancing is not completed as a result of performing operation S320, operation S280 may be performed.

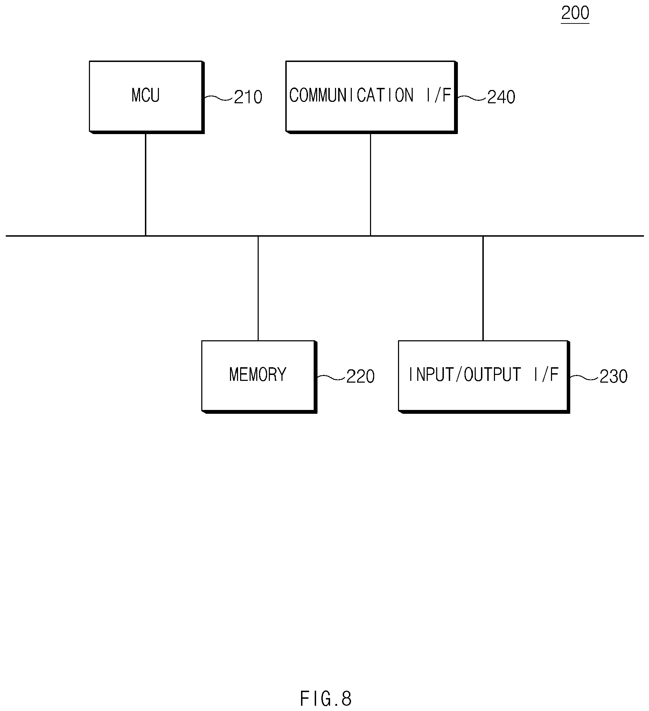

FIG. 8 illustrates a computing system that executes another battery management method, according to an embodiment disclosed herein.

Referring to FIG. 8, a computing system 200 according to an embodiment disclosed herein may include a microcontroller unit (MCU) 210, a memory 220, an input/output interface (I/F) 230, and a communication I/F 240.

The MCU 210 may be a processor that executes various programs (e.g., an SOH calculation program, a cell balancing target determination program, etc.) stored in the memory 220, processes various data including an SOC, an SOH, etc., of a plurality of battery cells through these programs, executes functions of the battery management apparatus 120 described above with reference to FIGS. 1 to 5, or executes the battery management method described with reference to FIGS. 6 and 7.

The memory 220 may store various programs regarding SOH calculation of the battery cell, cell balancing target determination, etc. Moreover, the memory 220 may store various data such as SOC data, SOH data, etc., of each battery cell.

The memory 220 may be provided in plural, depending on a need. The memory 220 may be a volatile memory or a nonvolatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., with the MCU 210.

The communication I/F 230, which is a component capable of transmitting and receiving various data to and from a server, may be various types of devices capable of supporting wired or wireless communication. For example, a program for SOH calculation of the battery cell or balancing target determination or various data, etc., may be transmitted and received to and from a separately provided external server through the communication I/F 230.

As such, the battery management method according to an embodiment disclosed herein may be recorded in the memory 220 and executed by the MCU 210.

The above description is merely illustrative of the technical idea of the present invention, and various modifications and variations will be possible without departing from the essential characteristics of embodiments of the present invention by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present invention is not limited by these embodiments disclosed herein. The protection scope of the technical spirit disclosed herein should be interpreted by the following claims, and all technical spirits within the same range should be understood to be included in the range of the present invention.

## Claims

1. A battery management apparatus comprising:
a sensing unit sensing an operating state of a target device;
a power managing unit managing power supply from an auxiliary battery based on the operating state of the target device; and
a control unit performing a cell balancing operation for a plurality of battery cells according to an operating mode determined based on the operating state of the target device.

2. The battery management apparatus of claim 1, wherein the power managing unit operates by using power originating from a battery module comprising the plurality of battery cells, when the target device is in a power-on state.

3. The battery management apparatus of claim 2, wherein the auxiliary battery is charged by using the power originating from the battery module, when the power managing unit is supplied with power from the battery module.

4. The battery management apparatus of claim 1, wherein the power managing unit is supplied with power from the auxiliary battery, when the target device is in a power-off state.

5. The battery management apparatus of claim 1, wherein, when the target device is in a power-on state, the control unit operates in a normal mode, calculates a cell balancing time for the plurality of battery cells, and performs the cell balancing operation based on the calculated time.

6. The battery management apparatus of claim 5, wherein, when the target device is switched to the power-off state before the cell balancing operation is terminated, the control unit switches the operating mode to the low-power mode and performs the cell balancing operation for a remaining time of the calculated time.

7. The battery management apparatus of claim 6, wherein the control unit switches the operating mode to the normal mode every preset time and monitors a voltage of the plurality of battery cells in the normal mode to re-calculate the cell balancing time.

8. The battery management apparatus of claim 7, wherein the preset time is determined based on at least one of specifications of the target device, characteristics of the plurality of battery cells, and a capacity of the auxiliary battery.

9. A battery management method comprising:
sensing an operating state of a target device;
managing power supply from an auxiliary battery based on the operating state of the target device; and
performing a cell balancing operation for a plurality of battery cells according to an operating mode determined based on the operating state of the target device.

10. The battery management method of claim 9, wherein the managing of the power supply from the auxiliary battery based on the operating state of the target device comprises being supplied with power from the auxiliary battery when the target device is in a power-off state.

11. The battery management method of claim 9, wherein the performing of the cell balancing operation for the battery cells according to the operating mode determined based on the operating state of the target device comprises operating in a normal mode, calculating a cell balancing time for the plurality of battery cells, and performing the cell balancing operation based on the calculated time, when the target device is in a power-on state.

12. The battery management method of claim 11, wherein the performing of the cell balancing operation for the battery cells according to the operating mode determined based on the operating state of the target device comprises switching the operating mode to the low-power mode and performing the cell balancing operation for a remaining time of the calculated time, when the target device is switched to the power-off state before the cell balancing operation is terminated.

13. The battery management method of claim 12, further comprising:
determining whether a preset time has elapsed; and
monitoring a voltage of the plurality of battery cells in the normal mode to re-calculate the cell balancing time, in a case where the preset time has elapsed.

14. A battery management system comprising:
a battery module comprising a plurality of battery cells and supplying power to a target device;
a battery management apparatus performing a cell balancing operation for a plurality of battery cells according to an operating mode determined based on an operating state of the target device, and generating a control command based on the operating state of the target device;
a switch connecting or disconnecting a first auxiliary battery of the target device to or from the battery management apparatus in response to the control command; and
a second auxiliary battery supplying power to the battery management apparatus.

15. The battery management system of claim 14, wherein the battery management apparatus generates a control command for opening the switch to disconnect the first auxiliary battery from the battery management apparatus, when the target device is in a power-off state.

16. The battery management system of claim 15, wherein the battery management apparatus generates a control command for short-circuiting the switch when the target device is in the power-off state, and the second auxiliary battery is charged using power originating from the battery module when the switch is short-circuited.

17. The battery management system of claim 14, wherein, when the target device is in the power-on state, the battery management apparatus operates in a normal mode, calculates a cell balancing time for the plurality of battery cells, and performs the cell balancing operation based on the calculated time.

18. The battery management system of claim 17, wherein, when the target device is switched to the power-off state before the cell balancing operation is terminated, the battery management apparatus switches the operating mode to the low-power mode and performs the cell balancing operation for a remaining time of the calculated time.
